# EUROPÄISCHE PATENTSCHRIFT

(11) **EP 3 092 444 B1**
(45) Veröffentlichungstag und Bekanntmachung des Hinweises auf die Patenterteilung: **15.07.2020**
(21) Anmeldenummer: 14825156.4
(22) Anmeldetag: 29.12.2014
(51) Int. Cl.: F24C 7/08, H03K 17/96, D06F 39/00

(54) **HAUSGERÄTEBEDIENVORRICHTUNG**
OPERATING DEVICE FOR DOMESTIC APPLIANCE
DISPOSITIF DE COMMANDE D'APPAREIL MÉNAGER

(30) Priorität: 10.01.2014 DE 102014200316
(43) Veröffentlichungstag der Anmeldung: 16.11.2016
(73) Patentinhaber: BSH Hausgeräte GmbH, 81739 München (DE)
(72) Erfinder: NEUHAUSER, Maximilian, 83339 Chieming/Egerer (DE); PLANKL, Manfred, 83374 Traunwalchen (DE); REINDL, Karl, 93059 Regensburg (DE); ZEI, Carsten, 93161 Sinzing (DE)
(86) Internationale Anmeldenummer: PCT/EP2014/079363
(87) Internationale Veröffentlichungsnummer: WO 2015/104194

(56) Entgegenhaltungen:
- EP-A1- 2 833 248
- WO-A1-2004/107062
- DE-A1-102006 022 965
- DE-A1-102010 030 315
- US-A1- 2010 020 534
- US-A1- 2013 033 450

## Beschreibung

Es sind berührungsempfindliche und/oder annäherungsempfindliche Bedienvorrichtungen mit einer Frontblende, welche eine Markierung aufweist, und einer Lichtquelle, welche dazu vorgesehen ist, die Markierung zu hinterleuchten, bekannt.

Ferner ist aus der DE 10 2004 038 752 B4 eine Hausgerätebedienvorrichtung bekannt, welche eine Bedienblende mit einer Berührfläche, eine LED-Anzeige sowie eine Sensoreinheit aufweist, wobei die Sensoreinheit eine Trägerfolie und ein Sensorelement umfasst und das Sensorelement als geätzte Struktur auf der Trägerfolie angeordnet ist.

Die Druckschrift US 2010/020534 A1 offenbart einen Heizkocher mit einer Heizeinheit in einer oberen Platte. Nach dem Einschalten bewirkt eine Lichtemissionssteuereinheit, dass das lichtemittierende Element der Bedieneinheit einer bedienbaren Bediensperrfreigabetaste leuchtet, so dass nur die Taste angezeigt wird und die anderen Tasten weniger sichtbar sind. Somit wird der Heizkocher in einen Sperrzustand versetzt. Wenn der Betätigungssperrfreigabetaster in dem Sperrzustand betätigt wird, wird mindestens ein elektrostatischer Tastendruck außer dem Betätigungssperrfreigabetaster betätigbar gemacht und das Leuchtelement der Betätigungseinheit leuchtet auf.

Die Druckschrift DE 10 2006 022965 A1 offenbart eine Bedieneinheit für Haushaltsgeräte zum Einbau hinter einer Blende des Haushaltsgeräts. Bei der Bedieneinheit mit einem Sensorelement ist ein Leuchtmittel auf einer der Blende abzuwendenden Seite der Leiterplatte angeordnet, ein Lichtleiter ist zumindest teilweise in einer Durchtrittsöffnung der Leiterplatte angeordnet und der Lichtleiter weist an einer der Blende zuzuwendenden Seite eine leitfähige, im Wesentlichen ebene Oberfläche auf, wobei das Sensorelement zumindest teilweise durch die leitfähige Oberfläche gebildet ist.

Die Druckschrift DE 10 2010 030315 A1 offenbart eine berührungsempfindliche Eingabeeinheit, welche für ein Hausgerät vorgesehen ist und weist mindestens einen Elektrodenträger auf, welcher ein Substrat und mehrere flächig auf eine Seite des Substrats aufgebrachte Elektrodenfelder aus einem ersten elektrisch leitfähigen Material aufweist, wobei der Elektrodenträger mit seiner anderen Seite an einer von einem Nutzer zur Bedienung der berührungsempfindlichen Eingabeeinheit zu berührenden Bedienfläche adhäsiv appliziert ist, jedes der Elektrodenfelder des Elektrodenträgers mit einem jeweiligen Kontaktfeld einer Leiterplatte über ein jeweiliges elektrisch leitfähiges Kontaktelement verbunden ist und das Kontaktelement zwischen jeweilig zugehörige Elektrodenfelder und Kontaktfelder elektrisch und mechanisch kontaktierend eingebracht ist.

Die Druckschrift WO 2004/107062 A1 offenbart einen Detektor für einen kapazitiven Kontaktschalter aus einem Flachmaterial bestehend aus einer transparenten Trägerfolie und einer ITO-Beschichtung.

Die Druckschrift US 2013/033450 A1 offenbart ein kapazitives Dual-Mode-Touchpanel umfassend ein Sensorsubstrat, eine Elektrodenschicht, die eine Anordnung von Sensorelektroden umfasst, die über dem Sensorsubstrat angeordnet sind, wobei die Anordnung von Sensorelektroden mehrere Ansteuerelektroden und mehrere Erfassungselektroden umfasst, wobei jede Sensorelektrode einer Lage auf dem Sensorsubstrat und einer Abschirmschicht entspricht, die über der Elektrodenschicht angeordnet und von dieser beabstandet ist. Die Abschirmschicht weist einen vorbestimmten Widerstand auf, wobei ein Abstand zwischen der Abschirmschicht und der Elektrodenschicht infolge einer ausgeübten Kraft verformbar auf die Abschirmschicht aufgrund einer Benutzerberührung ist, wobei die Verformung eine Kapazität zwischen der Abschirmschicht und einer Sensorelektrode des Arrays verändert. Eine Steuerung ist betriebsmäßig mit der Anordnung von Sensorelektroden gekoppelt, wobei die Steuerung konfiguriert ist, um die Abschirmschicht und mindestens einige Sensorelektroden der Sensorelektrodenanordnung bei der ersten Frequenz in einem ersten Modus anzusteuern.

Die nachveröffentlichte Druckschrift EP 2 833 248 A1 offenbart eine kapazitive Sensorvorrichtung mit einer Frontplatte aus Glas und einer elektrisch leitfähig beschichteten Sensorplatte aus Dünnglas (Dicke im Bereich von 0,2 bis 2 mm), wobei auf der Sensorplatte eine keramische Leitstruktur aus einer eingebrannten keramischen Leitpaste angeordnet ist. Die Druckschrift offenbart außerdem ein Verfahren zur Herstellung der kapazitiven Sensorvorrichtung.

Die Aufgabe der Erfindung besteht insbesondere darin, ein gattungsgemäßes Hausgerät mit einer Hausgerätebedienvorrichtung mit verbesserten Eigenschaften hinsichtlich einer Designfreiheit und/oder einer Bedienbarkeit bereitzustellen. Die Aufgabe wird durch die Merkmale des Patentanspruchs 1 gelöst, während vorteilhafte Ausgestaltungen und Weiterbildungen der Erfindung den Unteransprüchen entnommen werden können.

Es wird eine Hausgerätebedienvorrichtung mit einer Blendeneinheit, welche zumindest einen Bedienbereich aufweist, mit einer Beleuchtungseinheit, welche dazu vorgesehen ist, den zumindest einen Bedienbereich zu hinterleuchten und/oder zu durchleuchten, mit einer Sensoreinheit, die zumindest ein wenigstens teilweise transparentes Trägerelement und zumindest ein Sensorelement aufweist, welches als geätzte Struktur auf dem zumindest einen Trägerelement angeordnet ist, vorgeschlagen, wobei die Sensoreinheit wenigstens teilweise zwischen der Beleuchtungseinheit und der Blendeneinheit angeordnet ist.

Unter einer "Hausgerätebedienvorrichtung" soll dabei insbesondere zumindest ein Teil, insbesondere eine Unterbaugruppe, eines Hausgeräts verstanden werden, welche insbesondere zu einer Bedienung des Hausgeräts vorgesehen ist. Das Hausgerät ist dabei als ein beliebiges, einem Fachmann als sinnvoll erscheinendes Hausgerät ausgebildet, als ein Gargerät, insbesondere ein Backofen, ein Dampfgarer, ein Kochfeld, eine Mikrowelle und/oder ein Toaster, ein Waschgerät, insbesondere ein Geschirrspüler und/oder eine Waschmaschine, und/oder ein Kühlgerät, insbesondere ein Kühlschrank, ein Gefrierschrank und/oder eine Gefriertruhe. Ferner soll in diesem Zusammenhang unter einer "Blendeneinheit" insbesondere eine bauliche Einheit verstanden werden, welche zumindest ein Bauteil, insbesondere zumindest eine Abdeckblende, aufweist, welches dazu vorgesehen ist, die Hausgerätebedienvorrichtung und insbesondere das Hausgerät in zumindest eine Richtung hin abzudecken und/oder abzuschließen. Insbesondere dient die Blendeneinheit dabei zu einem Schutz der Hausgerätebedienvorrichtung und/oder der Sensoreinheit. Vorteilhaft ist die Blendeneinheit dabei einstückig ausgebildet. Insbesondere kann die Blendeneinheit dabei einstückig mit einer Kochfeldplatte ausgebildet sein. Unter "einstückig" soll in diesem Zusammenhang insbesondere zumindest stoffschlüssig verbunden verstanden werden. Der Stoffschluss kann beispielsweise durch einen Klebeprozess, einen Anspritzprozess und/oder einen anderen, einem Fachmann als sinnvoll erscheinenden Prozess hergestellt werden. Vorteilhaft soll unter einstückig jedoch in einem Stück geformt verstanden werden. Vorzugsweise wird dieses eine Stück aus einem einzelnen Element hergestellt.

Dabei ist zumindest ein Teil der Blendeneinheit, insbesondere zumindest teilweise transparent ausgebildet, insbesondere in zumindest einer Umgebung des zumindest einen Bedienbereichs. Insbesondere weist die Blendeneinheit wenigstens ein elektrisch isolierendes Material auf und besteht vorzugsweise zumindest im Wesentlichen aus einem elektrisch isolierenden Material, beispielsweise Glas, Glaskeramik und/oder einem Kunststoff. In diesem Zusammenhang soll unter "zumindest im Wesentlichen" aus einem Material bestehend insbesondere verstanden werden, dass ein Element mit einem Volumenanteil von zumindest 70 %, vorzugsweise von zumindest 80 % und besonders bevorzugt von zumindest 90 % aus diesem Material besteht. Vorteilhaft ist die Blendeneinheit und/oder das zumindest eine Bauteil zumindest im Wesentlichen flächig ausgebildet. Besonders vorteilhaft ist die Blendeneinheit und/oder das zumindest eine Bauteil zumindest im Wesentlichen plattenartig ausgestaltet. In diesem Zusammenhang soll unter einem "zumindest im Wesentlichen" flächigen Objekt ein Objekt verstanden werden, welches mit einem Volumenanteil von maximal 30 %, vorteilhaft maximal 20 %, vorzugsweise maximal 10 % und besonders bevorzugt maximal 5 % von einem Objekt abweicht, welches eine flache und/oder gebogene Form aufweist und insbesondere eine Materialstärke von maximal 5 mm, vorteilhaft von maximal 3 mm, vorzugsweise von maximal 1 mm und besonders bevorzugt von maximal 0,5 mm aufweist. Unter einer "zumindest im Wesentlichen" plattenartigen Ausgestaltung eines Objekts, soll insbesondere eine Ausgestaltung des Objekts verstanden werden, bei welcher ein minimaler, das Objekt gerade noch umhüllender geometrischer Quader eine längste Kante aufweist, die wenigstens 5-mal, insbesondere zumindest 10-mal, vorzugsweise mindestens 15-mal und besonders vorteilhaft wenigstens 20-mal so lang ist, wie eine kürzeste Kante des Quaders. Eine Materialstärke und/oder eine Länge einer kürzesten Kante eines minimalen, das Objekt gerade noch umhüllenden Quaders definiert, dabei insbesondere eine Dicke des Objekts. Ferner definiert eine längste Kante eines minimalen, das Objekt gerade noch umhüllenden Quaders, insbesondere eine Länge des Objekts. Eine Länge einer mittleren Kante eines minimalen, das Objekt gerade noch umhüllenden Quaders definiert, dabei insbesondere eine Breite des Objekts. Vorzugsweise ist die Blendeneinheit dabei derart angeordnet, dass wenigstens ein von der Beleuchtungseinheit ausgehender Lichtstrahl eine kleinste Erstreckung und/oder eine Dicke der Blendeneinheit und/oder des zumindest einen Bauteils, insbesondere zumindest im Wesentlichen parallel zu der Erstreckung und/oder der Dicke, durchdringt. Unter "zumindest im Wesentlichen" parallel soll hier insbesondere eine Ausrichtung einer Richtung relativ zu einer Bezugsrichtung, insbesondere in einer Ebene, verstanden werden, wobei die Richtung gegenüber der Bezugsrichtung eine Abweichung insbesondere kleiner als 8°, vorteilhaft kleiner als 5° und besonders vorteilhaft kleiner als 2° aufweist. Des Weiteren soll unter einer "Beleuchtungseinheit" insbesondere eine Einheit verstanden werden, welche in zumindest einem Betriebszustand dazu vorgesehen ist, Licht bereitzustellen und/oder zu führen. Insbesondere umfasst die Beleuchtungseinheit dabei zumindest einen Lichtleiter und/oder vorzugsweise zumindest eine Lichtquelle. Die zumindest eine Lichtquelle kann beispielsweise als Elektrolumineszenz-Folie, LED und/oder OLED ausgebildet sein. Ferner kann die Beleuchtungseinheit und/oder die zumindest eine Lichtquelle insbesondere dazu vorgesehen sein, einfarbiges und/oder mehrfarbiges Licht bereitzustellen. Insbesondere kann die Beleuchtungseinheit und/oder die zumindest eine Lichtquelle auch dazu vorgesehen sein, Licht unterschiedlicher Helligkeit bereitzustellen. Ferner soll unter einem "Bedienbereich" insbesondere ein Oberflächenbereich verstanden werden, welcher insbesondere an einer Oberfläche der Blendeneinheit und insbesondere an einer Oberfläche des Hausgeräts angeordnet ist. Insbesondere bildet der zumindest eine Bedienbereich zumindest eine Bedienfläche aus. Insbesondere ist der zumindest eine Bedienbereich dazu vorgesehen, von einem Bediener zu einer Bedieneingabe berührt und/oder durch zumindest eine Annäherung betätigt zu werden. Insbesondere kann die zumindest eine Bedienfläche in zumindest einem Betriebszustand dabei eine ebene Form, eine erhabene Form und/oder eine zumindest teilweise gebogene Form aufweisen. Insbesondere kann der zumindest eine Bedienbereich und/oder die zumindest eine Bedienfläche dabei dazu vorgesehen sein, in zumindest einem Betriebszustand wenigstens eine Position, vorzugsweise eine Bedienposition, eine Funktion und/oder einen Betriebszustand der Hausgerätebedienvorrichtung und/oder des Hausgeräts und/oder der Sensoreinheit, insbesondere anhand einer Durchleuchtung und/oder einer Hinterleuchtung, anzuzeigen. Dabei kann die Beleuchtungseinheit insbesondere dazu vorgesehen sein, einen Betriebszustand der Hausgerätebedienvorrichtung und/oder des Hausgeräts durch eine unterschiedliche Helligkeit und/oder eine unterschiedliche Leuchtfarbe anzuzeigen. Ein Ausmaß und/oder eine Begrenzung des zumindest einen Bedienbereichs kann dabei insbesondere durch eine Hinterleuchtung und/oder vorzugsweise durch eine Markierung gekennzeichnet sein. Die zumindest eine Markierung kann dabei insbesondere ein Symbol und/oder ein Piktogramm aufweisen, und insbesondere als Symbol und/oder Markierung ausgebildet sein. Insbesondere weist der zumindest eine Bedienbereich eine Flächenerstreckung von zumindest 0,1 cm², vorteilhaft von zumindest 0,5 cm², vorzugsweise von zumindest 1 cm² und besonders bevorzugt von zumindest 2 cm² und insbesondere von maximal 15 cm², vorteilhaft von maximal 10 cm², vorzugsweise von maximal 7 cm² und besonders bevorzugt von maximal 5 cm² auf. Des Weiteren soll unter einem "Sensorelement" insbesondere ein, vorzugsweise zumindest im Wesentlichen flächiges und besonders bevorzugt zumindest im Wesentlichen plattenartig ausgestaltetes Element verstanden werden, welches dazu vorgesehen ist, mittelbar und/oder unmittelbar eine Berührung und/oder Annäherung, vorzugsweise eine Berührung des zumindest einen Bedienbereichs und/oder eine Annäherung an den zumindest einen Bedienbereich, zu detektieren. Die Detektion kann dabei beispielsweise induktiv, resistiv und/oder vorzugsweise kapazitiv erfolgen. Das zumindest eine Sensorelement kann dabei aus jedem, einem Fachmann als sinnvoll erscheinenden, elektrisch leitfähigen Material bestehen. Insbesondere kann das zumindest eine Sensorelement dabei Ausnehmungen und/oder Hohlräume umgeben. Dabei weist das zumindest eine Sensorelement insbesondere eine Flächenerstreckung, insbesondere eine Flächenerstreckung einer äußeren Kontur, von zumindest 0,2 cm², vorteilhaft von zumindest 0,6 cm², vorzugsweise von zumindest 1,1 cm² und besonders bevorzugt von zumindest 2,1 cm² und insbesondere von maximal 20 cm², vorteilhaft von maximal 15 cm², vorzugsweise von maximal 10 cm² und besonders bevorzugt von maximal 6 cm² auf. Dabei weist das zumindest eine Sensorelement und/oder eine Außenkontur des zumindest einen Sensorelements, insbesondere eine größere Flächenerstreckung als der zumindest eine Bedienbereich und/oder die zumindest eine Markierung auf. Vorzugsweise weist die Sensoreinheit, ferner eine zusätzliche Schutzschicht auf, welche das zumindest eine Sensorelement umschließt und insbesondere zu einem Schutz des zumindest einen Sensorelements vorgesehen ist. Die Schutzschicht kann dabei insbesondere eine Folie und/oder einen Schutzlack aufweisen und vorzugsweise daraus gebildet sein. Unter einem "Trägerelement" soll ferner ein, insbesondere zumindest im Wesentlichen flächiges und vorzugsweise zumindest im Wesentlichen plattenartig ausgebildetes Element verstanden werden, welches insbesondere zumindest eine Aufnahmefläche aufweist, auf welcher, insbesondere zumindest in einem montierten Zustand, das zumindest eine Sensorelement angeordnet ist. Insbesondere kann auf der zumindest einen Aufnahmefläche auch genau ein Sensorelement oder auch mehrere Sensorelemente angeordnet sein. Insbesondere besteht das Trägerelement zumindest im Wesentlichen aus einem elektrisch isolierenden Material, insbesondere zumindest im Wesentlichen aus einem Kunststoff, vorzugsweise aus Polyethylenterephthalat (PET) und/oder Polyethylennaphthalat (PEN). Darunter, dass ein Objekt "zumindest teilweise transparent" ausgebildet ist, soll insbesondere verstanden werden, dass das Objekt wenigstens einen Teilbereich aufweist, welcher für wenigstens einen Wellenlängenbereich, vorzugsweise im sichtbaren Lichtspektrum, wenigstens teilweise transparent und/oder zumindest transluzent ist. Ferner soll unter einer "geätzten Struktur" insbesondere eine Struktur verstanden werden, welche durch Ätzen, insbesondere chemisches Ätzen, hergestellt ist. Die Sensoreinheit ist vorzugsweise mit einem Volumenanteil von zumindest 50 %, insbesondere von zumindest 70 % und besonders bevorzugt von zumindest 90 % zwischen der Beleuchtungseinheit und der Blendeneinheit angeordnet. Darunter, dass die Sensoreinheit "zwischen" der Beleuchtungseinheit und der Blendeneinheit angeordnet ist, soll in diesem Zusammenhang insbesondere verstanden werden, dass zumindest eine Gerade existiert, welche zumindest einen Punkt des Sensorelements, zumindest einen Punkt der Blendeneinheit und zumindest einen Punkt der Beleuchtungseinheit schneidet. Vorzugsweise ist die Sensoreinheit und/oder wenigstens das zumindest eine Sensorelement zumindest im Wesentlichen plattenartig ausgebildet und weist insbesondere eine Haupterstreckungsebene auf, welche insbesondere parallel zu einer größten seitlichen Flächenerstreckung eines minimalen geometrischen Quaders ist, welcher die Sensoreinheit und/oder das zumindest eine Sensorelement gerade noch vollständig umhüllt, und dabei durch einen Mittelpunkt des Quaders verläuft. In diesem Fall sind zumindest ein Teil der Blendeneinheit, insbesondere der zumindest eine Bedienbereich, vorzugsweise die gesamte Blendeneinheit, und die Beleuchtungseinheit, vorzugsweise die zumindest eine Lichtquelle, auf unterschiedlichen Seiten der Haupterstreckungsebene der Sensoreinheit und/oder wenigstens des zumindest einen Sensorelements angeordnet.

Durch diese Ausgestaltung kann insbesondere eine Designfreiheit und/oder eine Bedienbarkeit verbessert werden. Insbesondere kann dabei ein Betriebszustand und/oder eine Eigenschaft der Hausgerätebedienvorrichtung vorteilhaft angezeigt werden. Ferner können durch die Anwendung bekannter Leitertechnikverfahren, insbesondere bei der Herstellung des Trägerelements, Kosten sowie ein Arbeitsaufwand reduziert werden. Vorteilhaft kann dabei ferner eine Platzersparnis erreicht werden.

Das zumindest eine Sensorelement kann dabei insbesondere aus einem zumindest im Wesentlichen transparenten und/oder transluzenten Material, wie insbesondere einem leitfähigen Polymer und/oder Indiumzinnoxid bestehen. Vorteilhaft ist das zumindest eine Sensorelement jedoch zumindest im Wesentlichen und vorzugsweise vollständig opak. Darunter, dass ein Objekt "zumindest im Wesentlichen" opak ist, soll in diesem Zusammenhang insbesondere verstanden werden, dass das Objekt mit einem Volumenanteil von zumindest 50 %, vorzugsweise von zumindest 70 % und besonders bevorzugt von zumindest 90 % lichtundurchlässig ist. Insbesondere kann das zumindest eine Sensorelement dabei beispielsweise zumindest im Wesentlichen aus Silber und/oder zumindest im Wesentlichen aus Aluminium bestehen. Vorzugsweise besteht das zumindest eine Sensorelement jedoch zumindest im Wesentlichen aus Kupfer und/oder einer Kupferlegierung. Hierdurch können insbesondere Designs ermöglicht werden, welche sonst lediglich mit transparenten Materialien erreicht werden können. Ferner können vorteilhaft Kosten gesenkt werden.

Das zumindest eine Sensorelement weist eine Mehrzahl, insbesondere zumindest zwei, elektrisch miteinander verbundene Leiterbahnen auf. Die Leiterbahnen sind dabei über zumindest einen Verbindungsleiter, vorteilhaft an einem Randbereich, miteinander verbunden. Dabei weist zumindest ein Verbindungsleiter vorzugsweise eine größere Linienbreite als zumindest eine der Leiterbahnen auf und ist vorzugsweise aus einem gleichen Material wie die Leiterbahnen, gebildet. Hierdurch kann insbesondere eine kostengünstige Sensoreinheit realisiert werden.

Sind die Leiterbahnen, insbesondere zumindest zwei, vorzugsweise zumindest vier Leiterbahnen, zumindest im Wesentlichen parallel und/oder zumindest im Wesentlichen gitterförmig angeordnet, kann ein Sensorelement insbesondere konstruktiv einfach ausgestaltet und eine Detektion vorteilhaft verbessert werden.

Des Weiteren wird vorgeschlagen, dass die Leiterbahnen eine Linienbreite zwischen 0,01 mm und 0,6 mm, vorzugsweise zwischen 0,03 mm und 0,4 mm und besonders bevorzugt zwischen 0,05 mm und 0,3 mm aufweisen. Hierdurch kann insbesondere ein Herstellungsprozess der Sensoreinheit vereinfacht werden, da vorteilhaft bekannte Leitertechnikverfahren eingesetzt werden können.

Weiterhin wird vorgeschlagen, dass die Leiterbahnen einen gegenseitigen Abstand zwischen 0,05 mm und 1 mm, vorzugsweise zwischen 0,08 mm und 0,8 mm und besonders bevorzugt zwischen 0,1 mm und 0,5 mm aufweisen. Hierdurch kann insbesondere eine Sensitivität des Sensorelements sowie insbesondere ein, zumindest für ein menschliches Auge, unsichtbarer Anteil der Sensoreinheit an spezielle Anforderungen angepasst werden.

In einer Ausgestaltung der Erfindung wird vorgeschlagen, dass das zumindest eine Sensorelement zwischen 10 % und 85 %, vorzugsweise zwischen 15 % und 70 % und besonders bevorzugt zwischen 20 % und 50 %, einer Gesamtfläche des zumindest einen Trägerelements einnimmt. Hierdurch kann vorteilhaft eine Sensitivität des Sensorelements weiter verbessert werden.

In einer besonders bevorzugten Ausgestaltung der Erfindung wird vorgeschlagen, dass zumindest eine Gerade existiert, welche zumindest einen Punkt des Sensorelements, zumindest einen Punkt des Bedienbereichs, insbesondere einen Punkt der zumindest einen, insbesondere optionalen, Markierung des Bedienbereichs, und zumindest einen Punkt der Beleuchtungseinheit, vorteilhaft der zumindest einen Lichtquelle, schneidet. Hierdurch kann vorteilhaft eine Platzersparnis und eine erhöhte Designfreiheit erreicht werden.

Vorteilhaft ist das zumindest eine Trägerelement zumindest im Wesentlichen flexibel. Unter der Wendung "zumindest im Wesentlichen" flexibel, soll in diesem Zusammenhang insbesondere verstanden werden, dass das zumindest eine Trägerelement mit einem Volumenanteil von zumindest 50 %, vorzugsweise von zumindest 70 % und besonders bevorzugt von zumindest 90 % flexibel ist. Unter dem Ausdruck "flexibel" soll dabei insbesondere verstanden werden, dass das zumindest eine Trägerelement zumindest eine Erstreckung, vorzugsweise zwei Erstreckungen, vorzugsweise eine Länge und/oder eine Breite, aufweist, die insbesondere um zumindest 10 %, vorteilhaft um zumindest 25 %, vorzugsweise um zumindest 40 % und besonders bevorzugt um zumindest 60 % elastisch veränderbar ist. Vorteilhaft ist das zumindest eine Trägerelement dabei als eine Folie ausgebildet und weist insbesondere eine Dicke zwischen 10 µm und 500 µm, vorzugsweise zwischen 30 µm und 300 µm und besonders bevorzugt zwischen 50 µm und 100 µm auf. Hierdurch kann die Sensoreinheit und/oder die Hausgerätebedienvorrichtung vorteilhaft an eine dreidimensionale Struktur angepasst werden. Ferner kann eine Designfreiheit vorteilhaft weiter erhöht werden.

Ferner wird vorgeschlagen, dass die Sensoreinheit zumindest eine Zuleitung aufweist, welche als geätzte Struktur auf dem zumindest einen Trägerelement angeordnet ist. Insbesondere kann die Zuleitung dabei in demselben Arbeitsschritt wie das zumindest eine Sensorelement hergestellt werden. In diesem Zusammenhang soll unter einer "Zuleitung" insbesondere eine elektrisch leitfähige Verbindung verstanden werden, welche dazu vorgesehen ist, die Sensoreinheit mit einer Auswerteeinheit und/oder einer Steuereinheit mittelbar und/oder unmittelbar zu verbinden. Hierdurch kann insbesondere ein Arbeitsaufwand reduziert werden. Ferner können Kosten weiter gesenkt werden.

Vorteilhaft weist die Hausgerätebedienvorrichtung zumindest ein, vorzugsweise zumindest im Wesentlichen flächiges, Streuelement auf, welches dazu vorgesehen ist, eine direkte Sicht auf das zumindest eine Sensorelement zu verhindern. Unter einem "Streuelement" soll in diesem Zusammenhang insbesondere ein zumindest teilweise transparentes, vorzugsweise transluzentes, Element, vorzugsweise eine Beschichtung, eine Bedruckung und/oder eine Folie, verstanden werden, welches dazu vorgesehen ist, Licht als diffuses Licht zu transmittieren und somit insbesondere eine unscharfe Abbildung eines dahinterliegenden Objekts zu erzeugen. Das diffuse Licht kann dabei beispielswiese durch eine raue Oberfläche erzeugt werden. Ferner kann das diffuse Licht auch durch eine spezielle Beschichtung, Bedruckung und/oder Folie erzeugt werden, wobei das verwendete Material streuende Teilchen, wie insbesondere Calciumphosphat, Fluorid und/oder Zinnoxid, aufweist. Hierdurch kann insbesondere eine Designvielfalt der Hausgerätebedienvorrichtung weiter erhöht werden.

Ist das zumindest eine Trägerelement mit dem zumindest einen Streuelement einstückig ausgebildet, kann insbesondere eine Bauhöhe reduziert und Kosten eingespart werden. Weitere Vorteile ergeben sich aus der folgenden Zeichnungsbeschreibung. In der Zeichnung sind zwei Ausführungsbeispiele der Erfindung dargestellt. Die Zeichnung, die Beschreibung und die Ansprüche enthalten zahlreiche Merkmale in Kombination.

Es zeigen:
- Fig. 1: eine schematische Darstellung eines Hausgeräts mit einer Hausgerätebedienvorrichtung, welche eine Blendeneinheit aufweist,
- Fig. 2: eine vergrößerte Teilansicht der Blendeneinheit und eines Streuelements der Hausgerätebedienvorrichtung in einer seitlichen Schnittdarstellung,
- Fig. 3: eine schematische Darstellung einer Sensoreinheit der Hausgerätebedienvorrichtung mit zwei Sensorelementen,
- Fig. 4: eine schematische Darstellung der gesamten Hausgerätebedienvorrichtung in einer seitlichen Schnittdarstellung und
- Fig. 5: eine weitere Hausgerätebedienvorrichtung mit einer alternativen Sensoreinheit in einer seitlichen Schnittdarstellung.

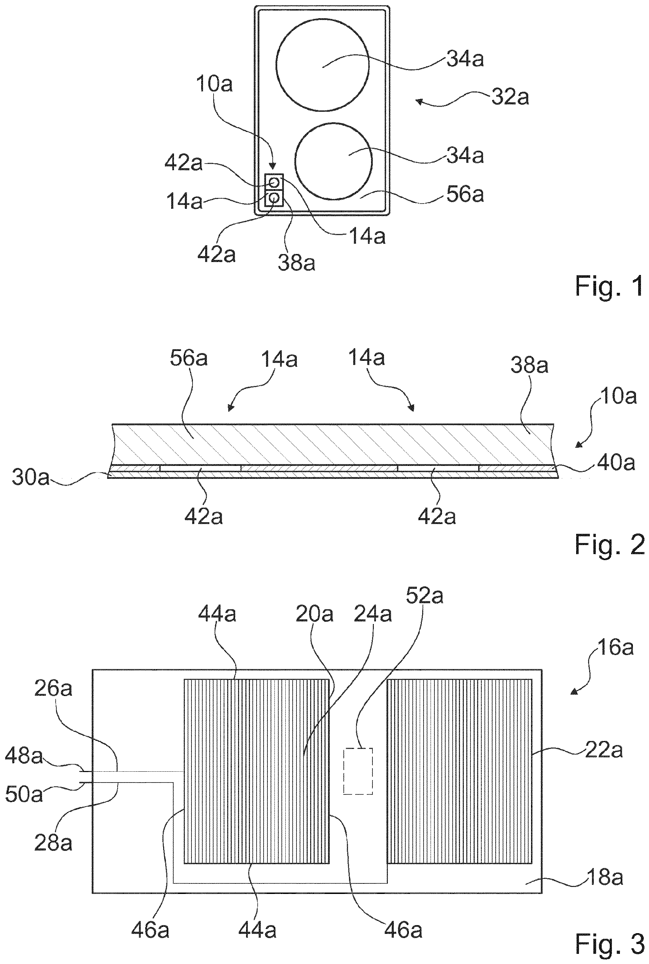

Figur 1 zeigt ein beispielhaftes als Kochfeld ausgebildetes Hausgerät 32a in einer schematischen Draufsicht. Das Hausgerät 32a weist eine Kochfeldplatte 56a mit zwei Heizzonen 34a auf. Ferner weist das Hausgerät 32a eine Hausgerätebedienvorrichtung auf. Die Hausgerätebedienvorrichtung dient dabei zur Eingabe und/oder Auswahl einer Leistungsstufe durch einen Benutzer. Des Weiteren weist die Hausgerätebedienvorrichtung eine Steuereinheit (nicht dargestellt) auf. Die Steuereinheit ist dazu vorgesehen, die Hausgerätebedienvorrichtung zu steuern und/oder eine Bedieneingabe auszuwerten.

Die Hausgerätebedienvorrichtung weist eine Blendeneinheit 10a auf (vgl. auch Figur 2). Die Blendeneinheit 10a ist zumindest teilweise einstückig mit der Kochfeldplatte 56a ausgebildet. Die Blendeneinheit 10a weist im vorliegenden Fall eine Dicke von 4 mm auf. Die Blendeneinheit 10a weist im vorliegenden Fall eine Glaskeramikplatte 38a auf. Die Glaskeramikplatte 38a ist zumindest teilweise als eine Bedienoberfläche ausgebildet. Die Glaskeramikplatte 38a ist im vorliegenden Fall zumindest teilweise transparent ausgebildet. Die Glaskeramikplatte 38a weist mehrere Bedienbereiche 14a auf. Die Glaskeramikplatte 38a weist im vorliegenden Fall zwei Bedienbereiche 14a auf. Die Bedienbereiche 14a sind im vorliegenden Fall als berührungsempfindliche Bedienbereiche 14a ausgebildet. Die Bedienbereiche 14a sind auf einer Oberseite der Glaskeramikplatte 38a angeordnet. Die Bedienbereiche 14a sind dazu vorgesehen, von einem Bediener durch eine Berührung betätigt zu werden. Dabei ist jeder Bedienbereich 14a einer der Heizzonen 34a zugeordnet. Die Bedienbereiche 14a sind eben ausgebildet. Im vorliegenden Fall sind die Bedienbereiche 14a zueinander identisch ausgebildet.

Ferner weist die Blendeneinheit 10a eine Beschichtung 40a auf. Die Beschichtung 40a ist auf einer Unterseite der Glaskeramikplatte 38a angeordnet. Die Beschichtung 40a ist opak. Im vorliegenden Fall ist die Beschichtung 40a schwarz. Die Beschichtung 40a erstreckt sich im Wesentlichen über die gesamte Glaskeramikplatte 38a. Dabei weist die Beschichtung 40a mehrere Aussparungen auf. Im vorliegenden Fall weist die Beschichtung 40a zwei Aussparungen auf. Jede der Aussparungen ist einem der Bedienbereiche 14a zugeordnet. Die Aussparungen bilden zwei Markierungen 42a. Die Markierungen 42a sind im vorliegenden Fall somit durch Aussparungen in der Beschichtung 40a gebildet. Somit sind die Markierungen 42a im vorliegenden Fall, insbesondere vollständig, transparent. Die Markierungen 42a sind zueinander identisch ausgebildet. Die Markierungen 42a weisen im vorliegenden Fall eine runde Form auf. Dabei weisen die Markierungen 42a einen Radius von etwa 0,5 cm auf. Die Markierungen 42a weisen somit eine Flächenerstreckung von etwa 0,8 cm² auf.

Alternativ kann eine Markierung auch durch eine Aussparung und/oder ein Loch einer Bedruckung, einer Folie und/oder eines Laserdrucks gebildet sein. Ferner ist denkbar, dass zumindest eine Markierung durch eine Beschichtung, eine Bedruckung, eine Folie, einen Laserdruck und/oder eine andere einem Fachmann als sinnvoll erscheinende Weise gebildet ist. Insbesondere kann zumindest eine Markierung auch teilweise transparent und/oder opak sein. Ferner kann zumindest eine Markierung jede einem Fachmann als sinnvoll erscheinende Form aufweisen, wie insbesondere eine quadratische Form, eine rechteckige Form, eine Form eines Symbols und/oder eine Form eines Piktogramms.

Ferner weist die Hausgerätebedienvorrichtung ein Streuelement 30a auf. Das Streuelement 30a ist, insbesondere direkt, unterhalb der Blendeneinheit 10a und/oder unterhalb der Beschichtung 40a angeordnet. Das Streuelement 30a ist dazu vorgesehen, eine direkte Sicht auf eine Sensoreinheit 16a zu verhindern. Das Streuelement 30a ist zumindest im Wesentlichen transparent. Das Streuelement 30a ist im vorliegenden Fall transluzent. Somit ist das Streuelement 30a lichtdurchlässig. Ferner ist das Streuelement 30a jedoch blickdicht. Das Streuelement 30a besteht im vorliegenden Fall aus einem Kunststoff. Das Streuelement 30a ist flächig ausgebildet. Das Streuelement 30a ist im vorliegenden Fall als Folie ausgebildet. Alternativ kann ein Streuelement auch als Bedruckung und/oder Beschichtung ausgebildet sein, insbesondere auf einer Blendeneinheit. Das Streuelement 30a ist im vorliegenden Fall, insbesondere direkt, unterhalb der Blendeneinheit 10a und/oder unterhalb der Beschichtung 40a angeklebt. Alternativ ist auch denkbar ein Streuelement festzuklemmen anstatt festzukleben.

Figur 3 zeigt eine schematische Darstellung der Sensoreinheit 16a der Hausgerätebedienvorrichtung. Die Sensoreinheit 16a weist ein Trägerelement 18a auf. Das Trägerelement 18a ist flächig ausgebildet. Das Trägerelement 18a ist als Folie ausgebildet. Im vorliegenden Fall weist das Trägerelement 18a eine Dicke von 80 µm auf. Somit ist das Trägerelement 18a im vorliegenden Fall flexibel. Das Trägerelement 18a ist ferner vollständig transparent. Das Trägerelement 18a ist aus einem Kunststoff gebildet. Im vorliegenden Fall ist das Trägerelement 18a aus PEN gebildet. Ferner weist das Trägerelement 18a eine rechteckige Außenkontur auf. Dabei weist das Trägerelement 18a eine Länge von etwa 4 cm und eine Breite von etwa 2 cm auf. Somit weist das Trägerelement 18a eine Flächenerstreckung von etwa 8 cm² auf.

Die Sensoreinheit 16a weist ferner mehrere Sensorelemente 20a, 22a auf. Die Sensorelemente 20a, 22a sind auf dem Trägerelement 18a, insbesondere einer Oberseite und/oder Unterseite des Trägerelements 18a, angeordnet. Im vorliegenden Fall sind zwei Sensorelemente 20a, 22a auf dem Trägerelement 18a angeordnet. Jedes der Sensorelemente 20a, 22a ist einer der Markierungen 42a zugeordnet. Die Sensorelemente 20a, 22a sind zueinander identisch. Die Sensorelemente 20a, 22a sind als geätzte Struktur auf dem Trägerelement 18a angeordnet. Somit sind die Sensorelemente 20a, 22a direkt auf das Trägerelement 18a geätzt. Die Sensorelemente 20a, 22a sind flächig ausgebildet. Die Sensorelemente 20a, 22a bestehen aus einem elektrisch leitenden Material. Die Sensorelemente 20a, 22a bestehen im vorliegenden Fall aus Kupfer. Somit sind die Sensorelemente 20a, 22a im vorliegenden Fall opak. Jedes der Sensorelemente 20a, 22a weist eine Mehrzahl elektrisch miteinander verbundener Leiterbahnen 24a auf. Der Übersichtlichkeit halber ist im vorliegenden Fall lediglich eine Leiterbahn mit einem Bezugszeichen versehen. Im vorliegenden Fall weist jedes der Sensorelemente 20a, 22a vierzig Leiterbahnen 24a auf. Die Leiterbahnen 24a eines der Sensorelemente 20a, 22a sind parallel angeordnet. Die Leiterbahnen 24a weisen im vorliegenden Fall eine Linienbreite von 0,1 mm auf. Dabei weisen die Leiterbahnen 24a einen gegenseitigen Abstand von 0,3 mm auf. Die Leiterbahnen 24a weisen ferner eine Dicke von 18 µm auf. Demnach sind die Leiterbahnen 24a und/oder die Sensorelemente 20a, 22a mit bloßem Auge sichtbar.

Des Weiteren weist jedes Sensorelement 20a, 22a im vorliegenden Fall vier Verbindungsleiter 44a, 46a auf, welche insbesondere der Übersichtlichkeit halber nur in einem der Sensorelemente 20a, 22a mit einem Bezugszeichen versehen sind. Jedes der Sensorelemente 20a, 22a ist somit aus Leiterbahnen 24a und Verbindungsleitern 44a, 46a gebildet. Die Verbindungsleiter 44a, 46a weisen im vorliegenden Fall eine größere Linienbereite als die Leiterbahnen 24a auf. Dabei weisen die Verbindungsleiter 44a, 46a eine Linienbreite von 0,2 mm auf. Zwei der Verbindungsleiter 46a sind parallel zu den Leiterbahnen 24a eines der Sensorelemente 20a, 22a angeordnet. Die zwei übrigen Verbindungsleiter 44a sind senkrecht zu den Leiterbahnen 24a eines der Sensorelemente 20a, 22a angeordnet. Die senkrechten Verbindungsleiter 44a sind dazu vorgesehen, die Leiterbahnen 24a eines der Sensorelemente 20a, 22a an ihren Randbereichen, insbesondere elektrisch leitend, miteinander zu verbinden. Alternativ ist auch denkbar, dass zumindest ein Sensorelement lediglich einen Verbindungsleiter, insbesondere einen senkrechten Verbindungsleiter, aufweist. Ferner ist denkbar, dass zumindest ein Verbindungsleiter einen beliebigen Winkel zu Leiterbahnen eines Sensorelements aufweist. Im vorliegenden Fall legen die Verbindungsleiter 44a, 46a eine Außenkontur eines der Sensorelemente 20a, 22a fest. Dabei weisen die Sensorelemente 20a, 22a im vorliegenden Fall eine rechteckige Außenkontur auf. Die Außenkontur eines der Sensorelemente 20a, 22a weist eine Breite von 1,6 cm und eine Länge von 1,9 cm auf. Die Außenkontur eines der Sensorelemente 20a, 22a schließt somit eine Flächenerstreckung von etwa 3 cm² ein. Alternativ kann zumindest ein Sensorelement auch eine quadratische, eine runde und/oder eine andere einem Fachmann als sinnvoll erscheinende Form aufweisen. Eine reine Materialfläche, insbesondere ein elektrisch leitfähiges Material, eines der Sensorelemente 20a, 22a nimmt eine Flächenerstreckung von etwa 0,8 cm² ein. Im vorliegenden Fall nimmt eines der Sensorelemente 20a, 22a somit etwa 10 % einer Gesamtfläche des Trägerelements 18a ein. Ferner sind beide Sensorelemente 20a, 22a identisch ausgebildet, so dass die beiden Sensorelemente 20a, 22a etwa 20 % einer Gesamtfläche des Trägerelements 18a einnehmen.

Im vorliegenden Fall weist die Sensoreinheit 16a ferner eine zusätzliche Schutzschicht (nicht dargestellt) auf. Die Schutzschicht umschließt zumindest eines der Sensorelemente 20a, 22a. Im vorliegenden Fall umschließt die Schutzschicht beide Sensorelemente 20a, 22a. Die Schutzschicht ist im vorliegenden Fall als Schutzlack ausgebildet. Die Schutzschicht ist transparent.

Ferner weist die Sensoreinheit 16a mehrere Zuleitungen 26a, 28a auf. Die Zuleitungen 26a, 28a sind auf dem Trägerelement 18a angeordnet. Im vorliegenden Fall sind zwei Zuleitungen 26a, 28a auf dem Trägerelement 18a angeordnet. Die Zuleitungen 26a, 28a sind als geätzte Struktur auf dem Trägerelement 18a angeordnet. Somit sind die Zuleitungen 26a, 28a direkt auf das Trägerelement 18a geätzt. Dabei sind die Zuleitungen 26a, 28a und die Sensorelemente 20a, 22a in demselben Arbeitsschritt auf das Trägerelement 18a geätzt. Die Zuleitungen 26a, 28a bestehen aus einem elektrisch leitenden Material. Im vorliegenden Fall bestehen die Zuleitungen 26a, 28a aus Kupfer. Die Zuleitungen 26a, 28a weisen im vorliegenden Fall eine Linienbreite von 0,15 mm auf. Dabei weisen die Zuleitungen 26a, 28a eine Dicke von 18 µm auf. Somit sind die Zuleitungen 26a, 28a im vorliegenden Fall opak. Ferner sind die Zuleitungen 26a, 28a mit bloßem Auge sichtbar. Jede der Zuleitungen 26a, 28a ist einem der Sensorelemente 20a, 22a zugeordnet. Jede der Zuleitungen 26a, 28a ist mit einem freien Ende mit einem der Verbindungsleiter 44a, 46a, insbesondere elektrisch leitend, verbunden. Im vorliegenden Fall ist jede der Zuleitungen 26a, 28a mit einem der senkrechten Verbindungsleiter 44a, insbesondere elektrisch leitend, verbunden. Ein zweites freies Ende jeder der Zuleitungen 26a, 28a weist im vorliegenden Fall einen Anschluss 48a, 50a auf. Der Anschluss 48a, 50a ist dazu vorgesehen, die Sensorelemente 20a, 22a mittelbar und/oder unmittelbar mit der Steuereinheit zu verbinden.

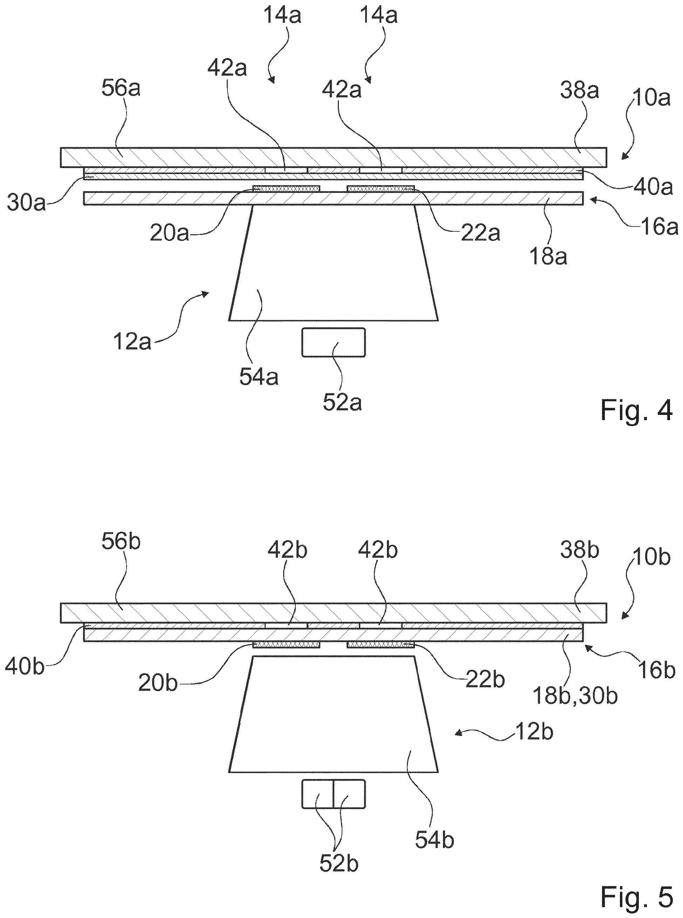

Figur 4 zeigt nun eine schematische Darstellung der Hausgerätebedienvorrichtung mit der Blendeneinheit 10a, dem Streuelement 30a, der Sensoreinheit 16a, welche lediglich schematisch als Fläche dargestellt ist, und einer Beleuchtungseinheit 12a in einer seitlichen Schnittdarstellung.

Die Hausgerätebedienvorrichtung weist eine Beleuchtungseinheit 12a auf. Die Beleuchtungseinheit 12a weist eine Lichtquelle 52a auf. Die Lichtquelle 52a ist als LED, insbesondere in SMD-Bauweise, ausgebildet. Die Lichtquelle 52a ist dazu vorgesehen, Licht unterschiedlicher Helligkeit bereitzustellen. Ferner weist die Beleuchtungseinheit 12a einen Lichtleiter 54a auf. Der Lichtleiter 54a ist dazu vorgesehen, das Licht der Lichtquelle 52a zu homogenisieren. Ferner ist die Sensoreinheit 16a oberhalb der Beleuchtungseinheit 12a angeordnet. Dabei ist die Sensoreinheit 16a direkt auf dem Lichtleiter 54a befestigt. Im vorliegenden Fall ist das Trägerelement 18a direkt auf den Lichtleiter 54a geklebt. Die Sensoreinheit 16a ist derart angeordnet, dass die Lichtquelle 52a zumindest im Wesentlichen zentral unterhalb der beiden Sensorelemente 20a, 22a angeordnet ist (vgl. auch Figur 3).

Dabei ist die Beleuchtungseinheit 12a und/oder die Sensoreinheit 16a unterhalb des Streuelements 30a angeordnet. Demnach ist die Beleuchtungseinheit 12a und/oder die Sensoreinheit 16a auch unterhalb der Blendeneinheit 10a angeordnet. Die Sensoreinheit 16a ist zwischen der Beleuchtungseinheit 12a und der Blendeneinheit 10a angeordnet. Die Sensoreinheit 16a ist derart angeordnet, dass die Sensorelemente 20a, 22a nach oben, insbesondere zu dem Streuelement 30a hin, weisen. Somit weist das Trägerelement 18a nach unten, insbesondere zu der Beleuchtungseinheit 12a hin. Demnach sind die Sensorelemente 20a, 22a im vorliegenden Fall oberhalb des Trägerelements 18a angeordnet. Ferner ist jedes der beiden Sensorelemente 20a, 22a im vorliegenden Fall zumindest im Wesentlichen zentral unterhalb einer der Markierungen 42a angeordnet. Dabei existiert zumindest eine Gerade welche zumindest einen Punkt des Sensorelements 20a, 22a, zumindest einen Punkt des Bedienbereichs 14a, insbesondere zumindest einen Punkt einer der Markierungen 42a und zumindest einen Punkt der Beleuchtungseinheit 12a, insbesondere des Lichtleiters 54a, schneidet. Die Beleuchtungseinheit 12a ist im vorliegenden Fall dazu vorgesehen, die Bedienbereiche 14a, insbesondere die Markierungen 42a, zu durchleuchten.

Ferner weist die Hausgerätebedienvorrichtung eine Leiterplatte (nicht dargestellt) auf. Die Leiterplatte ist unterhalb der Beleuchtungseinheit 12a angeordnet. Die Lichtquelle 52a ist unmittelbar auf die Leiterplatte gelötet. Ferner ist der Lichtleiter 54a unmittelbar an der Leiterplatte befestigt. Ein Abstand zwischen einer Unterseite des Trägerelements 18a und der Lichtquelle 52a beträgt im vorliegenden Fall etwa 0,5 cm. Die Blendeneinheit 10a ist im vorliegenden Fall über zwei Abstandshalter ebenfalls an der Leiterplatte befestigt.

Alternativ ist auch denkbar für jedes Sensorelement eine separate Beleuchtungseinheit und/oder Lichtquelle zu verwenden, welche insbesondere jeweils zentral unterhalb eines Sensorelements und/oder einer Markierung angeordnet sein kann. Ferner ist auch denkbar eine Lichtquelle in einem Winkel von beispielsweise 90° zu einer Längserstreckung einer Sensoreinheit anzuordnen, so dass Licht der Lichtquelle insbesondere über einen gebogenen Lichtleiter auf die Sensoreinheit geführt wird.

In der Figur 5 ist ein weiteres Ausführungsbeispiel der Erfindung gezeigt. Die nachfolgende Beschreibung und die Zeichnung beschränken sich im Wesentlichen auf die Unterschiede zwischen den Ausführungsbeispielen, wobei bezüglich gleich bezeichneter Bauteile, insbesondere in Bezug auf Bauteile mit gleichen Bezugszeichen, grundsätzlich auch auf die Zeichnungen und/oder die Beschreibung der anderen Ausführungsbeispiele, insbesondere der Figuren 1 bis 4, verwiesen werden kann. Zur Unterscheidung der Ausführungsbeispiele ist der Buchstabe a den Bezugszeichen des Ausführungsbeispiels in den Figuren 1 bis 4 nachgestellt. In dem Ausführungsbeispiel der Figur 5 ist der Buchstabe a durch den Buchstaben b ersetzt.

Figur 5 zeigt eine weitere Hausgerätebedienvorrichtung. Die Hausgerätebedienvorrichtung unterscheidet sich zumindest im Wesentlichen durch eine Ausgestaltung und eine Anordnung einer Sensoreinheit 16b. Die Sensoreinheit 16b weist ein Trägerelement 18b auf. Das Trägerelement 18b besteht dabei aus einem aufgerauten Kunststoff. Im vorliegenden Fall ist das Trägerelement 18b mit einem Streuelement 30b einstückig ausgebildet.

Ferner weist die Hausgerätebedienvorrichtung eine Blendeneinheit 10b mit einer Glaskeramikplatte 38b, einer Beschichtung 40b und zwei Markierungen 42b auf. Die Beschichtung 40b und/oder die Markierungen 42b sind auf einer Unterseite der Glaskeramikplatte 38b angeordnet.

Des Weiteren weist die Hausgerätebedienvorrichtung eine Beleuchtungseinheit 12b auf. Die Beleuchtungseinheit 12b weist im vorliegenden Fall einen Lichtleiter 54b auf. Des Weiteren weist die Beleuchtungseinheit 12b zwei Lichtquellen 52b auf. Beide Lichtquellen 52b sind dazu vorgesehen, einfarbiges Licht bereitzustellen. Im vorliegenden Fall sind beide Lichtquellen 52b dazu vorgesehen, unterschiedlich farbiges Licht bereitzustellen. Eine der Lichtquellen 52b ist dazu vorgesehen, rotes Licht bereitzustellen. Die andere Lichtquelle 52b ist dazu vorgesehen, blaues Licht bereitzustellen.

Die Sensoreinheit 16b ist unterhalb der Blendeneinheit 10b und/oder unterhalb der Beschichtung 40b angeordnet. Ferner ist die Sensoreinheit 16b oberhalb der Beleuchtungseinheit 12b angeordnet. Die Sensoreinheit 16b ist somit zwischen der Beleuchtungseinheit 12b und der Blendeneinheit 10b angeordnet. Im vorliegenden Fall ist die Sensoreinheit 16b an einer Unterseite der Beschichtung 40b und/oder der Glaskeramikplatte 38b der Blendeneinheit 10b befestigt.

Die Sensoreinheit 16b ist derart angeordnet, dass das Trägerelement 18b nach oben, insbesondere zu der Blendeneinheit 10b, weist. Somit weisen Sensorelemente 20b, 22b nach unten, insbesondere zu der Beleuchtungseinheit 12b. Demnach sind die Sensorelemente 20b, 22b im vorliegenden Fall unterhalb des Trägerelements 18b angeordnet.

### Bezugszeichen

- 10: Blendeneinheit
- 12: Beleuchtungseinheit
- 14: Bedienbereich
- 16: Sensoreinheit
- 18: Trägerelement
- 20: Sensorelement
- 22: Sensorelement
- 24: Leiterbahnen
- 26: Zuleitung
- 28: Zuleitung
- 30: Streuelement
- 32: Hausgerät
- 34: Heizzone
- 38: Glaskeramikplatte
- 40: Beschichtung
- 42: Markierung
- 44: Verbindungsleiter
- 46: Verbindungsleiter
- 48: Anschluss
- 50: Anschluss
- 52: Lichtquelle
- 54: Lichtleiter
- 56: Kochfeldplatte

## Patentansprüche

1. Hausgerät, und zwar Gargerät, Waschgerät oder Kühlgerät, mit zumindest einer Hausgerätebedienvorrichtung, welche zumindest eine Blendeneinheit (10a; 10b), welche zumindest einen Bedienbereich (14a; 14b) aufweist, eine Beleuchtungseinheit (12a; 12b), welche dazu vorgesehen ist, den zumindest einen Bedienbereich (14a; 14b) zu hinterleuchten und/oder zu durchleuchten, und eine Sensoreinheit (16a; 16b) aufweist, die zumindest ein wenigstens teilweise transparentes Trägerelement (18a; 18b) und zumindest ein Sensorelement (20a, 22a; 20b, 22b) aufweist, welches als geätzte Struktur auf dem zumindest einen Trägerelement (18a; 18b) angeordnet ist, wobei die Sensoreinheit (16a; 16b) wenigstens teilweise zwischen der Beleuchtungseinheit (12a; 12b) und der Blendeneinheit (10a; 10b) angeordnet ist, **dadurch gekennzeichnet, dass** das zumindest eine Sensorelement (20a, 22a; 20b, 22b) eine Mehrzahl elektrisch miteinander verbundene Leiterbahnen (24a; 24b) aufweist, wobei die Leiterbahnen (24a; 24b) dabei über zumindest einen Verbindungsleiter (44a; 46a) miteinander verbunden sind.

2. Hausgerät nach Anspruch 1, **dadurch gekennzeichnet, dass** das zumindest eine Sensorelement (20a, 22a; 20b, 22b) zumindest im Wesentlichen opak ist.

3. Hausgerät nach Anspruch 1 oder 2, **dadurch gekennzeichnet, dass** die Leiterbahnen (24a; 24b) zumindest im Wesentlichen parallel und/oder zumindest im Wesentlichen gitterförmig angeordnet sind.

4. Hausgerät nach einem der vorhergehenden Ansprüche, **dadurch gekennzeichnet, dass** die Leiterbahnen (24a; 24b) eine Linienbreite zwischen 0,01 mm und 0,6 mm aufweisen.

5. Hausgerät nach einem der vorhergehenden Ansprüche, **dadurch gekennzeichnet, dass** die Leiterbahnen (24a; 24b) einen gegenseitigen Abstand zwischen 0,05 mm und 1 mm aufweisen.

6. Hausgerät nach einem der vorhergehenden Ansprüche, **dadurch gekennzeichnet, dass** das zumindest eine Sensorelement (20a, 22a; 20b, 22b) zwischen 10 % und 85 % einer Gesamtfläche des zumindest einen Trägerelements (18a; 18b) einnimmt.

7. Hausgerät nach einem der vorhergehenden Ansprüche, **dadurch gekennzeichnet, dass** zumindest eine Gerade existiert, welche zumindest einen Punkt des Sensorelements (20a, 22a; 20b, 22b), zumindest einen Punkt des Bedienbereichs (14a; 14b) und zumindest einen Punkt der Beleuchtungseinheit (12a; 12b) schneidet.

8. Hausgerät nach einem der vorhergehenden Ansprüche **dadurch gekennzeichnet, dass** das zumindest eine Trägerelement (18a; 18b) zumindest im Wesentlichen flexibel ist.

9. Hausgerät nach einem der vorhergehenden Ansprüche, **dadurch gekennzeichnet, dass** die Sensoreinheit (16a; 16b) zumindest eine Zuleitung (26a, 28a; 26b, 28b) aufweist, welche als geätzte Struktur auf dem zumindest einen Trägerelement (18a; 18b) angeordnet ist.

10. Hausgerät nach einem der vorhergehenden Ansprüche, **dadurch gekennzeichnet, dass** die Hausgerätebedienvorrichtung zumindest ein Streuelement (30a; 30b) aufweist, welches dazu vorgesehen ist, eine direkte Sicht auf das zumindest eine Sensorelement zu verhindern.

11. Hausgerät zumindest nach Anspruch 10, **dadurch gekennzeichnet, dass** das zumindest eine Trägerelement (18b) mit dem zumindest einen Streuelement (30b) einstückig ausgebildet ist.

## Claims

1. Household appliance, specifically cooking appliance, laundry appliance or refrigeration appliance, with at least one household appliance operating device which has at least one panel unit (10a; 10b), which has at least one operating region (14a; 14b), a lighting unit (12a; 12b), which is provided to back-light and/or to transilluminate the at least one operating region (14a; 14b), and a sensor unit (16a; 16b), which has at least one at least partly transparent support element (18a; 18b) and at least one sensor element (20a, 22a; 20b, 22b) which is arranged on the at least one support element (18a; 18b) as an etched structure, wherein the sensor unit (16a; 16b) is arranged at least partly between the lighting unit (12a; 12b) and the panel unit (10a; 10b), **characterised in that** the at least one sensor element (20a, 22a; 20b, 22b) has a plurality of electrically interconnected conductor tracks (24a; 24b), wherein the conductor tracks (24a; 24b) are interconnected via at least one connection conductor (44a; 46a) in this context.

2. Household appliance according to claim 1, **characterised in that** the at least one sensor element (20a, 22a; 20b, 22b) is at least essentially opaque.

3. Household appliance according to claim 1 or 2, **characterised in that** the conductor tracks (24a; 24b) are arranged at least essentially in parallel and/or at least essentially in a grid shape.

4. Household appliance according to one of the preceding claims, **characterised in that** the conductor tracks (24a; 24b) have a line width of between 0.01 mm and 0.6 mm.

5. Household appliance according to one of the preceding claims, **characterised in that** the conductor tracks (24a; 24b) are at a mutual distance of between 0.05 mm and 1 mm.

6. Household appliance according to one of the preceding claims, **characterised in that** the at least one sensor element (20a, 22a; 20b, 22b) occupies between 10 % and 85 % of a total surface of the at least one support element (18a; 18b).

7. Household appliance according to one of the preceding claims, **characterised in that** there is at least one straight line which intersects at least one point of the sensor element (20a, 22a; 20b, 22b), at least one point of the operating region (14a; 14b) and at least one point of the lighting unit (12a; 12b).

8. Household appliance according to one of the preceding claims, **characterised in that** the at least one support element (18a; 18b) is at least essentially flexible.

9. Household appliance according to one of the preceding claims, **characterised in that** the sensor unit (16a; 16b) has at least one supply line (26a, 28a; 26b, 28b) which is arranged on the at least one support element (18a; 18b) as an etched structure.

10. Household appliance according to one of the preceding claims, **characterised in that** the household appliance operating device has at least one diffuser (30a; 30b) which is provided to prevent a direct view of the at least one sensor element.

11. Household appliance at least according to claim 10, **characterised in that** the at least one support element (18b) is integrally designed with the at least one diffuser (30b).

## Revendications

1. Appareil ménager, en particulier appareil de cuisson, appareil de lavage ou appareil frigorifique, comprenant au moins un dispositif de commande de l'appareil ménager, lequel comporte au moins une unité de diaphragme (10a; 10b) laquelle comprend au moins une zone de commande (14a; 14b), une unité d'éclairage (12a; 12b), laquelle est prévue pour éclairer par l'arrière et/ou par transpercement la au moins une zone de commande (14a; 14b), et une unité de détection (16a; 16b), qui comprend au moins un élément porteur (18a; 18b) au moins en partie transparent et au moins un élément de détection (20a, 22a; 20b, 22b), lequel est disposé en forme de structure gravée sur le au moins un élément porteur (18a; 18b), l'unité de détection (16a; 16b) étant disposée au moins en partie entre l'unité d'éclairage (12a; 12b) et l'unité de diaphragme (10a; 10b), **caractérisé en ce que** le au moins un élément de détection (20a, 22a; 20b, 22b) comprend une pluralité de pistes conductives (24a; 24b) raccordées les unes avec les autres à l'électricité, les pistes conductives (24a; 24b) étant raccordées l'une à l'autre par au moins un conducteur de raccordement (44a; 46a).

2. Appareil ménager selon la revendication 1, **caractérisé en ce que** le au moins un élément de détection (20a, 22a; 20b, 22b) est au moins essentiellement opaque.

3. Appareil ménager selon la revendication 1 ou 2, **caractérisé en ce que** les pistes conductives (24a; 24b) sont disposées au moins essentiellement parallèles et/ou au moins essentiellement en treillis.

4. Appareil ménager selon l'une des revendications précédentes, **caractérisé en ce que** les pistes conductives (24a; 24b) présentent une largeur de ligne entre 0,01 mm et 0,6 mm.

5. Appareil ménager selon l'une des revendications précédentes, **caractérisé en ce que** les pistes conductives (24a; 24b) présentent un écart mutuel entre 0,05 mm et 1 mm.

6. Appareil ménager selon l'une des revendications précédentes, **caractérisé en ce que** le au moins un élément de détection (20a, 22a; 20b, 22b) prend entre 10% et 85% de la surface totale du au moins un élément porteur (18a; 18b).

7. Appareil ménager selon l'une des revendications précédentes, **caractérisé en ce qu'**il existe au moins une droite qui coupe au moins un point de l'élément de détection (20a, 22a; 20b, 22b), au moins un point de la zone de commande (14a; 14b) et au moins un point de l'unité d'éclairage (12a; 12b).

8. Appareil ménager selon l'une des revendications précédentes, **caractérisé en ce que** le au moins un élément porteur (18a; 18b) est au moins essentiellement flexible.

9. Appareil ménager selon l'une des revendications précédentes, **caractérisé en ce que** l'unité de détection (16a; 16b) comprend au moins une conduite d'alimentation (26a, 28a; 26b, 28b), laquelle est disposée en forme de structure gravée sur le au moins un élément porteur (18a; 18b).

10. Appareil ménager selon l'une des revendications précédentes, **caractérisé en ce que** le dispositif de commande de l'appareil ménager comprend au moins un élément de dispersion (30a; 30b) prévu pour empêcher une vue directe sur le au moins un élément de détection.

11. Appareil ménager au moins selon la revendication 10, **caractérisé en ce que** le au moins un élément porteur (18b) est réalisé monobloc avec le au moins un élément de dispersion (30b).
